# EUROPEAN PATENT APPLICATION

(11) **EP 1 926 142 A1**
(43) Date of publication of application: **28.05.2008**
(21) Application number: 06798058.1
(22) Date of filing: 15.09.2006
(51) Int. Cl.: H01L 23/40

(54) **INSULATING CIRCUIT BOARD AND INSULATING CIRCUIT BOARD PROVIDED WITH COOLING SINK SECTION**

(30) Priority: 15.09.2005 JP 2005268093; 15.09.2005 JP 2005268094; 15.09.2005 JP 2005268095
(71) Applicant: MITSUBISHI MATERIALS CORPORATION, Chiyoda-ku, Tokyo 100-8117 (JP); TOYOTA JIDOSHA KABUSHIKI KAISHA, Toyota-shi Aichi 471-8571 (JP)
(72) Inventor: KUROMITSU, Yoshirou, Naka-shi, Ibaraki 311-0102 (JP); TORIUMI, Makoto, Naka-shi, Ibaraki 311-0102 (JP); NAGATOMO, Yoshiyuki, Naka-shi, Ibaraki 311-0102 (JP); ISHIZUKA, Hiroya, Naka-shi, Ibaraki 311-0102 (JP); BABA, Youichiro, Toyota-shi, Aichi 471-8571 (JP); WATANABE, Tomoyuki, Toyota-shi, Aichi 471-8571 (JP); YASUI, Takuya, Toyota-shi, Aichi 471-8571 (JP)
(74) Representative: HOFFMANN EITLE
(86) International application number: PCT/JP2006/318395
(87) International publication number: WO 2007/032486

(57) **Abstract**

An insulating circuit board includes an insulating plate, a circuit board joined to a first surface of the insulating plate, and a metal plate joined to a second surface of the insulating plate. The circuit board is formed from an A1 alloy having a purity of 99.98% or more or pure A1, and the metal plate is formed from an A1 alloy having a purity of 98.00% or more and 99.90% or less. The thickness (a) of the circuit board is for example 0.2 mm or more and 0.8 mm or less, the thickness (b) of the metal plate is for example 0.6 mm or more and 1.5 mm or less, and the thicknesses satisfy the expression of a/b ≤1. An insulating circuit board having a cooling sink includes the insulating circuit board, and a cooling sink joined to the metal plate via a second solder layer. The second solder layer is formed from solder containing Sn as its main component, and having a Young's modulus of, for example, 35 GPa or more, a 0.2% proof stress of, for example, 30 MPa or more, and a tensile strength of, for example, 40 MPa or more. The cooling sink is formed from, for example, pure A1 or an A1 alloy.

## Description

### TECHNICAL FIELD

The present invention relates to an insulating circuit board and an insulating circuit board having a cooling sink which are used for semiconductor equipments which control large current and high voltage.

This application claims priority from Japanese Patent Application Nos. 2005-268093, 2005-268094, and 2005-268095 filed on September 15, 2005, the contents of which are incorporated herein by reference.

### BACKGROUND ART

As this type of insulating circuit board having a cooling sink, there is, for example, an insulating circuit board as shown in Patent Document 1. This insulating circuit board generally includes an insulating circuit board including an insulating plate formed from ceramic, a circuit board joined to one surface of the insulating plate and a metal plate joined to the other surface of the insulating plate, and a cooling portion provided in the lower surface of the metal plate opposite to its surface joined to the insulating plate. Here, semiconductor chips are joined to the surface of the circuit board via a solder layer.

The cooling portion includes a heat radiating plate and a cooling sink into which a coolant is supplied, and these heat radiating plate and cooling sink are configured such that they are tightened and connected together with screws via thermally conductive grease (for example, silicone grease) therebetween. Also, the heat radiating plate of the cooling portion is joined to the metal plate via a solder layer.

Meanwhile, as the output of a power module in which semiconductor chips are joined to the surface of a circuit board in an insulating circuit board having a cooling sink has increased in recent years, the need for reducing the total thermal resistance of the power module in a laminated direction has increased without reducing the joining reliability between individual components constituting the power module. However, the thermally conductive grease was a great hindrance to reducing the total thermal resistance.

Patent Document 1: Japanese Patent Application, First publication No. H08-264680

### DISCLOSURE OF THE INVENTION

### Problems to be Solved by the Invention

The invention has been made in consideration of such circumstances. It is therefore an object of the invention to provide an insulating circuit board and an insulating circuit board having a cooling sink, which are capable of reducing the total thermal resistance in a laminated direction without reducing the joining reliability among individual components.

### Means for Solving the Problems

In order to achieve the above object, a first aspect of an insulating circuit board of the present invention includes an insulating plate, a circuit board joined to one surface of the insulating plate, and a metal plate joined to the other surface of the insulating plate, wherein the insulating circuit board is made such that semiconductor chips can be joined to the surface of the circuit board via a first solder layer, the insulating circuit board is made such that a cooling sink can be joined to the lower surface of the metal plate opposite to its surface joined to the insulating plate, via a second solder layer, the circuit board is formed from an A1 alloy having a purity of 99.98% or more, or pure A1, and the metal plate is formed from an A1 alloy having a purity of 98.00% or more and 99.90% or less.

In the first aspect of the insulating circuit board of the present invention, the circuit board is formed from an Al alloy having a purity of 99.98% or more, or pure Al, and the metal plate is formed from an Al alloy having a purity of 98.00% or more and 99.90% or less. For this reason, even if a power module is formed in which thermally conductive grease is not interposed and the number of joining interfaces is reduced, thereby reducing the total thermal resistance in a laminated direction, cracks can be prevented from being generated and growing in the first solder layer and the second solder layer by directly joining the metal plate to the cooling sink via the second solder layer.

That is, if the circuit board is formed from an A1 alloy having a purity of 99.98% or more or pure Al, it is possible to make a large strain accumulate in the circuit board when a heat cycle acts on the power module, to thereby suppress the amount of strain to be accumulated in the first solder layer, and it is possible to prevent cracks from being generated and growing in the first solder layer.

Further, if the metal plate is formed from an A1 alloy having a purity of 98.00% or more and 99.90% or less, it is possible to work-harden the metal plate by a strain which is accumulated in the metal plate when a heat cycle acts on the power module. For this reason, it is possible to reduce the contribution of the insulating plate in the thermal deformation behavior of the whole insulating circuit board, while it is possible to increase the contribution of the metal plate. Accordingly, the thermal expansion coefficient of the whole insulating circuit board increases apparently, and the difference between the thermal expansion coefficient of the insulating circuit board and the thermal expansion coefficient of the cooling sink becomes small. As a result, it is possible to reduce the amount of strain to be accumulated in the second solder layer, and it is possible to prevent cracks from being generated and growing in the second solder layer.

From the above, it is possible to provide an insulating circuit board capable of reducing the total thermal resistance of the power module in a laminated direction without reducing the joining reliability between the individual components constituting the power module.

The thickness (a) of the circuit board may be set to 0.2 mm or more and 0.8 mm or less, the thickness (b) of the metal plate may be set to 0.6 mm or more and 1.5 mm or less, and the thicknesses may satisfy the expression of a/b ≤1.

In this case, the stress generated in the first solder layer and the second solder layer can be further relieved.

That is, the thickness (b) of the metal plate is made large such that thickness is 0.6 mm or more and 1.5 mm or less, and the thickness satisfies a/b ≤ 1. In this case, even if the insulating plate with a small thermal expansion coefficient is joined to the upper surface of the metal plate and thereby the thermal deformation on the side of the upper surface of the metal plate is constrained by the insulating plate, it is possible to prevent the thermal deformation on the side of the lower surface of the metal plate from being constrained by the insulating plate. Further, the thickness (a) of the circuit board is made small such that the thickness is 0.2 mm or more and 0.8 mm or less, and the thickness satisfies a/b ≤ 0. In this case, the semiconductor chips and the insulating plate which have small thermal expansion coefficients are joined to the upper and lower surfaces of the circuit board, respectively, and thereby the thermal deformation of the circuit board can be uniformly constrained without any bias.

If the thickness of the circuit board is smaller than 0.2 mm, the amount of current that can flow into the circuit board becomes low. Further, if this thickness is larger than 0.8 mm, the effect that the thermal deformation of the circuit board is uniformly constrained without any bias by the insulating plate becomes relatively small, and consequently the crack growth rate at the time of the heat cycle in the first solder layer becomes large. Accordingly, although the thickness of the circuit board is not limited, the joining reliability can be further improved if the thickness is 0.2 to 0.8 mm.

If the thickness of the metal plate is smaller than 0.6 mm, not only the thermal deformation on the side of the upper surface of the metal plate but also the thermal deformation on the side of the lower surface thereof are constrained by the insulating plate, and consequently the crack growth rate at the time of the heat cycle in the second solder layer becomes large. Further, if this thickness is larger than 1.5 mm, the insulating plate and the circuit board are deformed due to the thermal deformation of the metal plate, and thereby the crack growth rate at the time of the heat cycle in the first solder layer becomes large. Accordingly, although the thickness of the metal plate is not limited, the joining reliability can be further improved if the thickness is 0.6 to 1.5 mm.

A first aspect of an insulating circuit board having a cooling sink of the present invention includes the aforementioned insulating circuit board, and a cooling sink joined to the lower surface of the metal plate opposite to its surface joined to the insulating plate, via the second solder layer, wherein the second solder layer is formed from a solder containing Sn as its main component.

In this insulating circuit board having a cooling sink, the metal plate and the cooling sink are joined together by the second solder layer containing Sn as its main component. Thus, even when a stress is generated in a joining interface due to difference in the thermal expansion coefficients of the cooling sink and the insulating plate, it is possible to absorb this stress by the second solder layer, and consequently it is possible to further improve the joining reliability of the power module.

The second solder layer may have a Young's modulus of 35 GPa or more, a 0.2% proof stress of 30 MPa or more, and a tensile strength of 40 MPa or more.

In this case, it is possible to make a large amount of strain accumulate in the metal plate when a heat cycle acts on a power module having the insulating circuit board having a cooling sink, to thereby suppress the amount of strain to be accumulated in the second solder layer. As a result, cracking can be prevented from being caused in the second solder layer in cooperation with the effect that the metal plate can be work-hardened.

The second solder layer may be formed from solder including a ternary or more multi-component alloy containing 85 wt% or more of Sn, 0.5 wt% or more of Ag, and 0.1 wt% or more of Cu.

A second aspect of the insulating circuit board of the present invention includes an insulating plate, a circuit board joined to one surface of the insulating plate, and a metal plate joined to the other surface of the insulating plate, wherein the insulating circuit board is made such that semiconductor chips can be joined to the surface of the circuit board, the insulating circuit board is made such that a cooling sink can be joined to the lower surface of the metal plate opposite to its surface joined to the insulating plate, the circuit board and the metal plate are formed from pure A1 or an A1 alloy, the thickness (a) of the circuit board is 0.2 mm or more and 0.8 mm or less, the thickness (b) of the metal plate is 0.6 mm or more and 1.5 mm or less, and the thicknesses satisfy the expression of a/b≤1.

In this insulating circuit board, the circuit board and the metal plate are formed from pure A1 or an A1 alloy, and the thickness (a) of the circuit board is 0.2 mm or more and 0.8 mm or less, the thickness (b) of the metal plate is 0.6 mm or more and 1.5 mm or less, and the thicknesses satisfy the expression of a/b ≤ 1. Therefore, even if a power module is formed in which thermally conductive grease is not interposed and the number of joining interfaces is reduced, thereby reducing the total thermal resistance in a laminated direction, the stress generated in joining portions between the semiconductor chips and the circuit board and in a joining portion between the metal plate and the cooling sink can be relieved by directly joining the metal plate to the cooling sink.

That is, the thickness (b) of the metal plate is made large such that the thickness is 0.6 mm or more and 1.5 mm or less and the thickness satisfies a/b ≤1. Therefore, even if the insulating plate which has a small thermal expansion coefficient is joined to the upper surface of the metal plate and thereby the thermal deformation on the side of the upper surface of the metal plate is constrained by the insulating plate, it is possible to prevent the thermal deformation on the side of the lower surface of the metal plate from being constrained by the insulating plate. Further, the thickness (a) of the circuit board is made small such that the thickness is 0.2 mm or more and 0.8 mm or less, and the thickness satisfies a/b≤1. Therefore, the semiconductor chips and the insulating plate which have small thermal expansion coefficients are joined to the upper and lower surfaces of the circuit board, respectively, and thereby the thermal deformation of the circuit board can be uniformly constrained without any bias.

From the above, it is possible to provide an insulating circuit board capable of reducing the total thermal resistance of the power module in a laminated direction without reducing the joining reliability between the individual components constituting the power module.

A second aspect of the insulating circuit board having a cooling sink of the present invention includes the insulating circuit board according to the above second aspect, and a cooling sink joined to the lower surface of the metal plate, wherein the insulating circuit board having a cooling sink is made such that semiconductor chips can be joined to the surface of the circuit board via a first solder layer, the cooling sink is formed from pure Al or an Al alloy, and the metal plate and the cooling sink are joined together via a second solder layer containing Sn as its main component.

According to this insulating circuit board having a cooling sink, the metal plate and the cooling sink are joined together by the second solder layer containing Sn as its main component. Thus, even when a stress is generated in a joining interface due to difference in the thermal expansion coefficients of the cooling sink and the insulating plate, it is possible to absorb this stress by the second solder layer, and consequently it is possible to further improve the joining reliability of the power module.

A third aspect of the insulating circuit board having a cooling sink of the present invention includes: an insulating circuit board including an insulating plate, a circuit board joined to one surface of the insulating plate, and a metal plate joined to the other surface of the insulating plate; and a cooling sink provided in the lower surface of the metal plate opposite to its surface joined to the insulating plate, wherein the insulating circuit board having a cooling sink is made such that semiconductor chips can be joined to the surface of the circuit board via a first solder layer, and the metal plate and the cooling sink are joined together via a second solder layer containing Sn as its main component and having a Young's modulus of 35 GPa or more, a 0.2% proof stress of 30 MPa or more, and a tensile strength of 40 MPa or more.

In this insulating circuit board having a cooling sink, the metal plate and the cooling sink are directly joined together via the second solder layer, whereby thermally conductive grease is not interposed, and the number of joining interfaces of the insulating circuit board having a cooling sink is reduced. For this reason, it is possible to reduce the total thermal resistance of the power module in a laminated direction in which semiconductor chips are joined to the circuit board.

Meanwhile, in this case, the thermal expansion coefficient difference between the insulating plate and the cooling sink is large. Thus, there is a possibility that a large stress may be generated between the metal plate and the cooling sink, and the joining reliability may decrease.

However, in the third aspect, the metal plate and the cooling sink are joined together by the second solder layer whose Young's modulus, 0.2% proof stress, and tensile strength are set to the above magnitudes, respectively. Thus, even when a stress is generated in a joining interface, it is possible to absorb this stress by the second solder layer because the thermal expansion coefficients of the cooling sink and the insulating plate are different from each other. Moreover, if the Young's modulus, and the like of the second solder layer are set to the above magnitudes, it is possible to make a large plastic strain accumulate in the metal plate when a heat cycle acts on the insulating circuit board having a cooling sink, to thereby suppress the amount of plastic strain to be accumulated in the second solder layer, and it is possible to prevent cracks from being generated in the second solder layer.

From the above, it is possible to reduce the total thermal resistance of the power module in a laminated direction without reducing the joining reliability between the individual components constituting the power module.

The second solder layer may be formed from solder including a ternary or more multi-component alloy containing 85 wt% or more of Sn, 0.5 wt% or more ofAg, and 0.1 wt% or more of Cu.

The cooling sink may be formed from pure Al or an Al alloy.

The circuit board and the metal plate may be formed from pure Al or an Al alloy, the thickness (a) of the circuit board may be 0.2 mm or more and 0.8 mm or less, the thickness (b) of the metal plate may be 0.6 mm or more and 1.5 mm or less, and the thicknesses may satisfy the expression of a/b ≤1.

### Effects of the Invention

According to the present invention, it is possible to provide an insulating circuit board and an insulating circuit board having a cooling sink which are capable of reducing the total thermal resistance in a laminated direction without reducing the joining reliability between individual components.

### BRIEF DESCRIPTION OF THE DRAWINGS

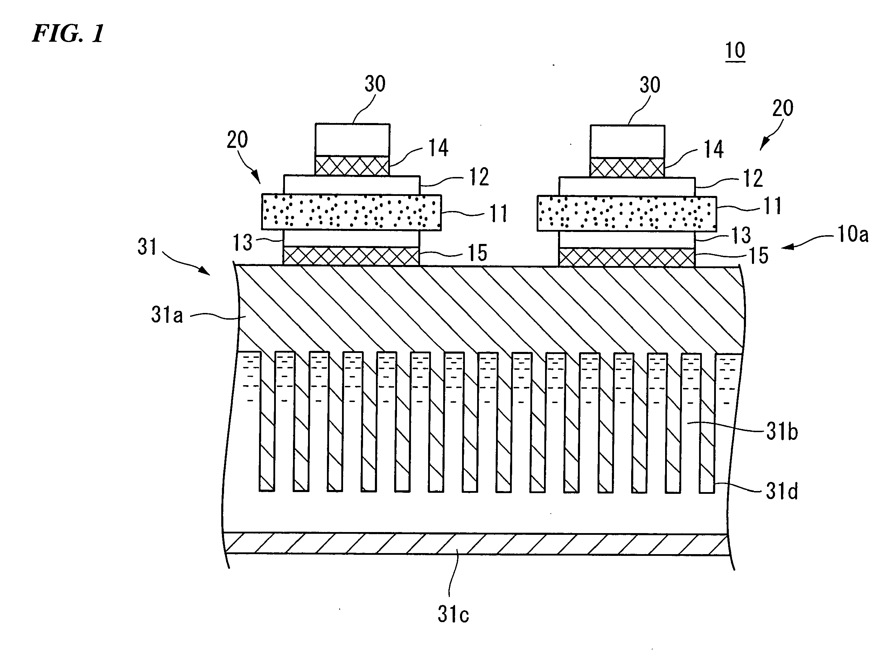

FIG. 1 is a general view showing a power module using an insulating circuit board according to one embodiment of the present invention.

### Description of the Reference Numerals

10 power module, 10a insulating circuit board having cooling sink, 11 insulating plate, 12 circuit board, 13 metal plate, 14 first solder layer, 15 second solder layer, 20 insulating circuit board, 30 semiconductor chip, 31 cooling sink

### BEST MODE FOR CARRYING OUT THE INVENTION

Hereinafter, embodiments of the present invention will be described with reference to the accompanying drawings.

A power module 10 of the present embodiment includes an insulating circuit board 20, semiconductor chips (heat generating elements) 30 provided on the side of one surface of the insulating circuit board 20, and a cooling sink 31 provided on the side of the other surface of the insulating circuit board 20. In other words, the power module 10 includes an insulating circuit board 10a having a cooling sink including the insulating circuit board 20 and the cooling sink 31, and the semiconductor chips 30.

The insulating circuit board 20 includes an insulating plate 11, a circuit board 12 joined to one surface of the insulating plate 11, and a metal plate 13 joined to the other surface of the insulating plate 11. Also, the semiconductor chips 30 are joined to the surface of the circuit board 12 via a first solder layer 14. The cooling sink 31 is provided on the lower surface of the metal plate 13 opposite to its surface joined to the insulating plate 11.

Here, an Ni-plated layer (not shown) having a thickness of about 2 µm is formed on the surface of each of the circuit board 12 and the metal plate 13, the semiconductor chip 30 is joined to the surface of the circuit board 12 on which the Ni-plated layer is formed, via the first solder layer 14, and the surface of each of the circuit board 12 and the metal plate 13 on which the Ni-plated layer is formed, and the insulating plate 11 are joined together by soldering.

In addition, in a case where the insulating plate 11 is formed from nitride-based ceramic such as AlN, Si₃N₄, or the like or oxide-based ceramic such as Al₂O₃ or the like, and the circuit board 12 and the metal plate 13 are formed from pure A1 or an A1 alloy, especially in a case where the circuit board 12 is formed from an A1 alloy having a purity of 99.98% or more or pure A1, and the metal plate 13 is formed from an A1 alloy having a purity of 98.00% or more and 99.90% or less, a solder material which joins the insulating plate 11 and the circuit board 12 or the metal plate 13 includes one solder material or two or more solder materials selected from solder materials including Al-Si-based solder materials, Al-Ge-based solder materials, Al-Cu-based solder materials, Al-Mg-based solder materials, and Al-Mn-based solder materials.

The cooling sink 31 is formed from a metal such as pure Al, an Al alloy having a purity of 90% or more, pure Cu, a Cu alloy, or the like, or a metal ceramic composite material such as AlSiC or the like, and includes a main body 31a on the surface of which the metal plate 13 is provided, and a box 31c in the surface of which an opening communicating with an inner space 31 b is formed. Here, although the main body 31 a is desirably formed from any one material selected from metals such as pure A1, an A1 alloy, pure Cu, a Cu alloy, or the like and metal ceramic composite materials such as AlSiC or the like in terms of manufacture, it can also be formed from a composite in which a plurality of materials are laminated. For example, a composite can be taken in which the portion of the main body 31a on the side of the inner space 31b is formed of pure Al, and a pure Cu plate is provided on the portion of the main body 31a on the side of the metal plate 13. In this case, since the pure Cu plate has a thermal expansion coefficient intermediate between the thermal expansion coefficient of the pure Al, and the thermal expansion coefficient of AIN (insulating plate 11), it functions as a stress absorbing member. A plurality of cooling fins 31d which extend downward and extend in the width direction (the depth direction of the sheet plane of FIG. 1) of the main body 31a are formed at a predetermined interval in the length direction (in the right-and-left direction of the sheet plane of FIG.1) of the main body 31 a in the lower surface of the main body 31 a opposite to its upper surface. In addition, from the viewpoints of heat transfer, workability, and the like, the main body 31 a is desirably made of pure A1 or an A1 alloy, and particularly the A1 alloy desirably has a purity of 98% or more.

The cooling sink 31 is configured such that the lower surface of the main body 31a closes the opening of the box 31c in a state where the cooling fins 31d of the main body 31 a project into the inner space 31 b of the box 31 c. Moreover, the cooling sink 31 is configured such that thermally conductive grease is not interposed between the lower surface of the main body 31a, and the peripheral edge of the opening in the surface of the box 31 c, but rather the lower surface of the main body 31a and the peripheral edge of the opening in the surface of the box 31c come into direct contact with each other.

Also, a coolant circulating unit (not shown) is provided which supplies and recovers coolant such as cooling liquid, cooling air, and the like to the closed inner space 31b. This unit allows the coolant to contact the entire areas of the lower surface of the main body 31 a and the cooling fins 31 d.

That is, the heat conducted from the semiconductor chips 30 to the cooling sink 31 is recovered by the coolant supplied to the inner space 31b; thereby, the heat from the semiconductor chips 30 is radiated from the power module 10. In addition, the heat transfer coefficient of the main body 31a of the cooling sink 31 is preferably set from about 6000 W/°C·m² to about 15000 W/°C·m².

Furthermore, in the present embodiment, the metal plate 13 and the main body 31 a are joined together by a second solder layer 15 containing Sn as its main component, and having a Young's modulus of 35 GPa or more, a 0.2% proof stress of 30 MPa or more, and a tensile strength of 40 MPa or more. Ni-plated layers (not shown) (having a thickness of about 2 µm on the metal plate 13 and a thickness of about 5 µm on the main body 31 a) are formed on the surfaces of the metal plate 13 and the main body 31 a that face each other, and the Ni-plated layers and the second solder layer 15 are joined together. In the illustrated example, almost the whole area of the lower surface of the metal plate 13 is joined by the second solder layer 15. Further, the second solder layer 15 is preferably formed from a solder including a ternary or more multi-component alloy containing 85 wt% or more of Sn, 0.5 wt% or more of Ag, and 0.1 wt% or more of Cu. The contents of the Sn, Ag, and Cu are more preferably Ag: 2 to 6 wt%, Cu: 0.3 to 4 wt%, and Sn: the balance.

In addition, although the material of the first solder layer 14 is not particularly limited, it is desirable that it be formed from a solder containing Sn as its main component.

Although the length, width, and thickness of the insulating plate 11 are not limited, for example, the length may be set from 10 mm to 100 mm, the width may be 10 mm to 100 mm, and the thickness may be 0.2 mm to 1.0 mm. Although the length, width, and thickness of the circuit board 12 are not limited, for example, it is preferable that the length be set from 10 mm to 100 mm, the width be set from 10 mm to 100 mm, and the thickness be set from 0.2 mm or more to 0.8 mm or less. Although the length, width, and thickness of the metal plate 13 are not limited, for example, it is preferable that the length be set from 10 mm to 100 mm, the width be set from 10 mm to 100 mm, and the thickness be set from 0.6 mm or more to 1.5 mm or less. In the case where such a power module 10 is used within a temperature range of -40°C to 105 °C, the thicknesses of the first solder layer 14 and the second solder layer 15 are preferably 0.05 mm to 0.5 mm.

Further, in the above numerical range, the thickness of the circuit board 12 is made smaller than the thickness of the metal plate 13, and when the thickness of the metal plate 13 is defined as "a", and the thickness of the circuit board 12 is defined as "b", it is preferable to satisfy the relationship of a/b ≤1.

In the power module 10 according to the present embodiment, the circuit board 12 is formed from an A1 alloy having a purity of 99.98% or more or pure A1, and the metal plate 13 is formed from an A1 alloy having a purity of 98.00% or more and 99.90% or less. For this reason, by directly joining the metal plate 13 to the main body 31a of the cooling sink 31 via the second solder layer 15, a power module 10 is formed in which thermally conductive grease is not interposed and the number of joining interfaces is reduced, and the total thermal resistance in a laminated direction is reduced. Even in the powder module, cracks can be prevented from being generated and growing in the first solder layer 14 and the second solder layer 15.

That is, if the circuit board 12 is formed from an A1 alloy having a purity of 99.98% or more or pure A1, it is possible to make a large strain accumulate in the circuit board 12 when a heat cycle acts on the power module 10, to thereby suppress the amount of strain to be accumulated in the first solder layer 14, and it is possible to prevent cracks from being generated and growing in the first solder layer 14.

Further, if the metal plate 13 is formed from an Al alloy having a purity of 98.00% or more and 99.90% or less, it is possible to work-harden the metal plate 13 by a strain which is accumulated in the metal plate 13 when a heat cycle acts on the power module 10, and it is possible to reduce the contribution of the insulating plate 11 in the thermal deformation behavior of the whole insulating circuit board 20, while it is possible to increase the contribution of the metal plate 13. Accordingly, the thermal expansion coefficient of the whole insulating circuit board 20 increases apparently, and the difference between the thermal expansion coefficient of the insulating circuit board 20 and the thermal expansion coefficient of the cooling sink 31 becomes small. As a result, it is possible to reduce the amount of strain to be accumulated in the second solder layer 15, and it is possible to prevent cracks from being generated and growing in the second solder layer 15.

From the above, it is possible to provide an insulating circuit board 20 capable of reducing the total thermal resistance of the power module 10 in a laminated direction without reducing the joining reliability between the individual components constituting the power module 10.

Further, in the present embodiment, since the thicknesses of the circuit board 12 and the metal plate 13 are set to the above range, the stresses generated in the first solder layer 14 and the second solder layer 15 can be relieved.

That is, in the case where the thickness (b) of the metal plate 13 is made large such that thickness is 0.6 mm or more and 1.5 mm or less, and the thickness satisfies a/b ≤ 1, even if the insulating plate 11 with a small thermal expansion coefficient is joined to the upper surface of the metal plate 13 and thereby the thermal deformation on the side of the upper surface of the metal plate 13 is constrained by the insulating plate 11, it is possible to prevent the thermal deformation on the side of the lower surface of the metal plate 13 from being constrained by the insulating plate 11.

Further, in the case where the thickness (a) of the circuit board 12 is made small such that the thickness is 0.3 mm or more and 0.8 mm or less, and the thickness satisfies a/b ≤ 1, the semiconductor chips 30 and the insulating plate 11 which have a small thermal expansion coefficient are joined to the upper and lower surfaces of the circuit board 12, respectively, and thereby the thermal deformation of the circuit board 12 can be uniformly constrained without any bias.

Here, if the thickness of the circuit board 12 is smaller than 0.2 mm, the amount of current that can flow to the circuit board 12 becomes low. Further, if this thickness is larger than 0.8 mm, the effect that the thermal deformation of the circuit board 12 is uniformly constrained without any bias by the insulating plate 11 becomes relatively small, and consequently the crack growth rate at the time of the heat cycle in the first solder layer 14 becomes large. Accordingly, although the thickness of the circuit board is not limited, the joining reliability can be further improved if the thickness is 0.2 to 0.8 mm.

If the thickness of the metal plate 13 is smaller than 0.6 mm, not only the thermal deformation on the side of the upper surface of the metal plate 13 but also the thermal deformation on the side of the lower surface thereof are constrained by the insulating plate 11, and consequently the crack growth rate at the time of the heat cycle in the second solder layer 15 becomes large. Further, if this thickness is larger than 1.5 mm, the insulating plate 11 and the circuit board 12 are deformed due to the thermal deformation of the metal plate 13, and thereby the crack growth rate at the time of the heat cycle in the first solder layer 14 becomes large. Accordingly, although the thickness of the metal plate is not limited, the joining reliability can be further improved if the thickness is 0.6 to 1.5 mm.

Further, in the present embodiment, the metal plate 13 and the cooling sink 31 (main body 31a) are joined together by the second solder layer 15 containing Sn as its main component. Thus, even when a stress tends to be generated in a joining interface due to difference in the thermal expansion coefficients of the cooling sink 31 (main body 31 a) and the insulating plate 11, it is possible to absorb this stress by the second solder layer 15. Consequently, it is possible to further improve the joining reliability of the power module 10.

Moreover, in the case where the Young's modulus, 0.2% proof stress, and tensile strength of the second solder layer 15 are set to the above magnitudes, it is possible to make a large amount of strain accumulate in the metal plate 13 when a heat cycle acts on the power module 10, to thereby reduce the amount of strain to be accumulated in the second solder layer 15. For this reason, cracking can be prevented from being caused in the second solder layer 15 in cooperation with the effect that the metal plate 13 can be work-hardened.

### EXAMPLES

### (First Verification Experiment)

Here, among the above effects, the effect that cracks can be prevented from being generated and growing in the first solder layer 14 and the second solder layer 15 by forming the circuit board 12 from an Al alloy having a purity of 99.98% or more or pure Al and by forming the metal plate 13 from an Al alloy having a purity of 98.00% or more and 99.90% or less was verified by an experiment (hereinafter referred to as "first verification experiment").

The following configuration was adopted as an insulating circuit board having a cooling sink provided for this experiment.

The insulating plate 11 was formed from a material containing AIN as its main component, and the length, width, and thickness thereof were 50 mm, 50 mm, and 0.635 mm, respectively. The circuit board 12 was formed from an A1 alloy, and the length, width, and thickness thereof were 48 mm, 48 mm, and 0.4 mm, respectively. The metal plate 13 was formed from an Al alloy, and the length, width, and thickness thereof were 48 mm, 48 mm, and 0.6 mm, respectively. The cooling sink 31 was formed from an Al alloy of the AA (Aluminum Association) 6063, and the length, width, and thickness of the main body 31a thereof were 100 mm, 100 mm, and 3 mm, respectively. The thickness (size in the horizontal direction of the sheet plane of FIG. 1), length (size in the vertical direction of the sheet plane of FIG. 1), and pitch of the cooling fins 31d were 1 mm, 8 mm, and 3 mm, respectively. The second solder layer 15 included Sn, 3.5% of Ag, and 0.75% of Cu, and the thickness thereof was 0.3 mm.

In the above configuration, 36 types of insulating circuit boards having a cooling sink, which were different from one another in terms of the purity of Al of Al alloys which formed the circuit board 12 and the metal plate 13, were formed. Hereinafter, among the insulating circuit boards, configurations in which the purity of an Al alloy that formed the circuit board 12 was 99.98% or more, and the purity of an Al alloy that formed the metal plate 13 was 98.00% or more and 99.90% or less are referred to as first examples, and configurations other than the first examples are referred to as first comparative examples.

In addition, joining of the metal plate 13 and the main body 31a of the cooling sink 31 via the second solder layer 15 was implemented under a reduction atmosphere whose temperature was set to 300°C, after Ni-plated layers were formed in advance on the surface of the main body 3 1a of the cooling sink to which the metal plate 13 was to be joined, and on the surface of the metal plate 13, by electroless plating. Further, concurrently with this joining, heater chips using AIN whose length, width, and thickness were set to 10 mm, 10 mm, and 0.3 mm, respectively, were joined to the circuit board 12 by the same solder material as the second solder layer 15. The heater chips were adopted instead of the semiconductor chips 30 in implementing this verification test (hereinafter, these configurations are referred to as "power modules"). Moreover, the circuit board 12, the metal plate 13, and the insulating plate 11 were vacuum-soldered in advance using an Al-Si solder foil. In addition, during this soldering, an Ni-plated layer having a thickness of 2 µm was formed in advance on the surface of each of the circuit board 12 and the metal plate 13 by electroless plating.

Each of the above power modules was placed under a liquid phase atmosphere composed of a fluorinated solvent, and a temperature cycle where a temperature hysteresis whose ambient temperature was caused to rise from -40°C to 105°C for 10 minutes and was caused to fall from 105°C to -40°C for 10 minutes was made as one cycle was applied to each power module. Then, the number of heat cycles when a rise of 10% or more was confirmed in a thermal resistance compared with a value before the temperature cycle was applied (hereinafter referred to as "initial thermal resistance value") was measured as the heat cycle lifespan of this power module. Here, when cracks were generated and grow in joining portions of the first solder layer14 and the second solder layer 15, and the like, a thermal resistance value will rise. Measurement of this heat cycle lifespan was made by measuring a thermal resistance value whenever 500 cycles was repeated.

In addition, measurement of the thermal resistance value was performed by the following method. Cooling water having a water temperature of 50°C was circulated through the inner space 31b of the cooling sink 31, and the external surface of the cooling fins 31 d was kept at constant temperature. In this state, the electric power of 100 W was supplied to the heater chip, thereby generating heat. After the temperature of the heater chip became constant, the thermal resistance value (HR) was calculated from HR = (Th - 50) /100 (°C/W) depending on the temperature (Th) of the heater chip and the temperature (50°C) of the cooling water. The heater chip temperature (Th) was calculated from Th = ΔR / TCR + Tr (°C) (Tr is a room temperature) by measuring TCR (Temperature Coefficient of Resistance) of the heater chip in advance, and by obtaining the difference (ΔR) between the resistance values of the heater chip before and after generation of heat.

As a conventional example, a configuration was adopted in which the same heater chip, insulating plate 11, circuit board 12, metal plate 13, and cooling sink 31 as those of the power module were adopted, and a heat radiating plate made of a CuMo alloy, whose length, width, and thickness were set to 70 mm, 70 mm, and 3 mm, respectively, was disposed between the metal plate 13 and the cooling sink 31. In addition, in the configuration of this conventional example, first, the circuit board 12, the metal plate 13 and the insulating plate 11 were vacuum-soldered together using an Al-Si solder foil. Thereafter, using a solder material containing 50% of Pb, and Sn, a heater chip and the circuit board 12 were joined together, and the heat radiating plate and the metal plate 13 were joined together. Moreover, the heat radiating plate and the cooling sink 31 were bonded together via a silicone grease layer whose thickness was about 0.15 mm. In addition, an Ni-plated layer was also formed on the surface of each of the circuit board 12, and the like similarly to the first examples and the first comparative examples.

As a result, it was confirmed that the initial thermal resistance value of the conventional example was 0.72 (°C/W), whereas the initial thermal resistance value of the first example was 0.28 (°C/W) to 0.30 (°C/W), and herewith the initial thermal resistance value of the first example could be made as small as a half compared with that of the conventional example. Further, as shown in Table 1, it was confirmed that the heat cycle lifespans in the first comparative examples were 3000 or less, whereas the heat cycle lifespans in the first examples were larger than 3500.

It was confirmed from the above that, with the power module 10 in which the purity of an Al alloy that forms the circuit board 12 is 99.98% or more and the purity of an Al alloy that forms the metal plate 13 is 98.00% or more and 99.90% or less, the total thermal resistance in the laminated direction can be reduced without reducing the joining reliability between the individual components of the circuit board 12, and the like.

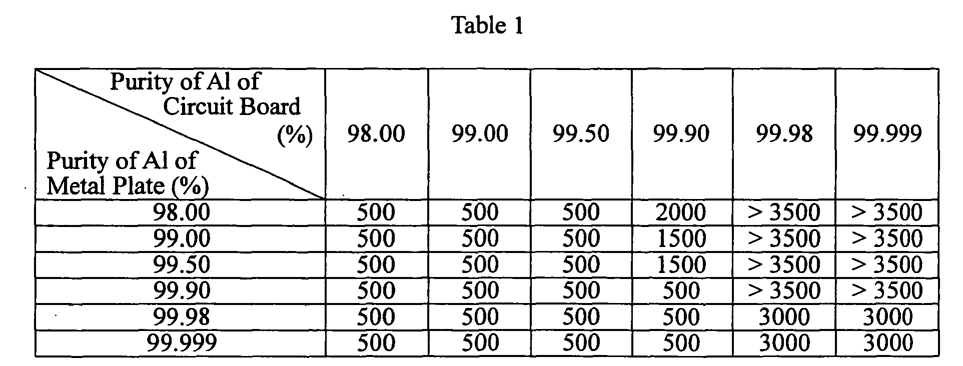

### (Second Verification Experiment)

Next, the effect that the stresses generated in the first solder layer 14 and the second solder layer 15 due to a heat cycle could be relieved by setting the thickness of the metal plate 13 and the thickness of the circuit board 12 to the above ranges was verified by an experiment (hereinafter referred to as "second verification experiment").

As power modules provided for this experiment, there were adopted 49 types of power modules having the same configurations as the power modules adopted in the first verification experiment, except that the circuit board 12 was formed from an Al alloy having a purity of 99.99%, the metal plate 13 was formed from an Al alloy having a purity of 99.50%, and the thicknesses of the circuit board 12 and the metal plate 13 varied within a range from 0.2 mm to 1.5 mm. Hereinafter, configurations in which the thickness (a) of the circuit board 12 was 0.2 mm or more and 0.8 mm or less, the thickness (b) of the metal plate 13 was 0.6 mm or more and 1.5 mm or less, and the expression of a/b ≤ 1 is satisfied are referred to as second examples, and configurations other than these second examples are referred to as second comparative examples.

The temperature cycle was applied to each of the above power modules similarly to the first verification experiment, and then the heat cycle lifespan was measured.

As a result, it was confirmed that the initial thermal resistance value of the second examples also were 0.28 (°C/W) to 0.30 (°C/W) similarly to the first examples, and the initial thermal resistance values of the second examples could be made smaller than half of that of the conventional example shown in the first verification experiment. Further, as shown in Table 2, it was confirmed that the heat cycle lifespans in the second comparative examples were 3000 or less, whereas the heat cycle lifespans in the second example were larger than 3500.

It was confirmed from the above that, with the power module 10 in which the thickness (a) of the circuit board 12 is 0.2 mm or more and 0.8 mm or less, the thickness (b) of the metal plate 13 is 0.6 mm or more and 1.5 mm or less, and the expression of a/b ≤ 1 is satisfied, the total thermal resistance in the laminated direction can be reduced without reducing the joining reliability between the individual components of the circuit board 12, and the like.

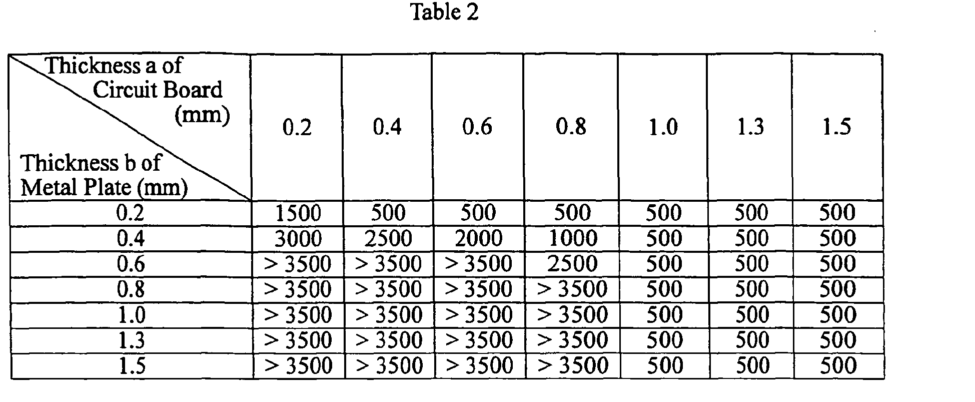

### (Third Verification Experiment)

Next, the verification experiment to determine that cracking could be prevented from being caused in the second solder layer 15 by setting the Young's modulus, 0.2% proof stress, and tensile strength of the second solder layer 15 to the above magnitudes, respectively, was implemented.

As power modules provided for this experiment, there were prepared 10 types of power modules having the same configurations as the power modules adopted in the first verification experiment, except that the circuit board 12 was formed from an A1 alloy having a purity of 99.99%, the metal plate 13 was formed from an A1 alloy having a purity of 99.50%, and the material of the second solder layer 15 varied.

Hereinafter, cases where the material of the second solder layer 15 was a solder including a ternary or more multi-component alloy containing 85 wt% or more of Sn, 0.5 wt% or more of Ag, and 0.1 wt% or more of Cu are referred to as third examples, and configurations other than the third examples are referred to as second comparative examples.

The temperature cycle was applied to each of the above power modules similarly to the first verification experiment, and then the heat cycle lifespan was measured.

As a result, it was confirmed that the initial thermal resistance values of the third examples (Examples 1 to 5) were also 0.28 (°C/W) to 0.30 (°C/W) similarly to the first and second examples, and the initial thermal resistance values of the third example could be made smaller than half of that (0.72 (°C/W)) of the conventional example shown in the first verification experiment. Further, as shown in Table 3, it was confirmed that the heat cycle lifespans in the third comparative examples (Comparative Examples 1 to 4) were 3000 or less, whereas the heat cycle lifespans in the third example were larger than 3500, and the heat cycle lifespans in the third example could be maintained equally to the conventional example.

It was confirmed from the above that it is possible to provide a power module capable of reducing the total thermal resistance in the laminated direction without reducing the joining reliability between the individual components of the circuit board 12, and the like.

**Table 3**

| | Second Solder (wt%) | Initial Thermal Resistance (°C/W) | Young's Modulus (Gpa) | 0.2% Proof Stress (MPa) | Tensile Strength (MPa) | Heat Cycle Lifespan (Number of Cycles) |
|---|---|---|---|---|---|---|
| Example 1 | Sn-3.5Ag-0.75Cu | 0.281 | 45 | 38 | 53 | > 3500 |
| Example 2 | Sn-4.7Ag-1.2Cu | 0.290 | 50 | 57 | 62 | > 3500 |
| Example 3 | Sn-3.5Ag-0.75Cu -0.01Ge | 0.288 | 45 | 40 | 55 | > 3500 |
| Example 4 | Sn-4.7Ag-1.2Cu -0.01Ge | 0.279 | 51 | 58 | 64 | > 3500 |
| Example 5 | Sn-3.2Ag-2.8Bi -0.7Cu-0.01Ge | 0.294 | 52 | 69 | 85 | > 3500 |
| Comparative Example 1 | Sn-0.75Cu | 0.296 | 34 | 22 | 32 | 1500 |
| Comparative Example 2 | Sn-0.7Cu-0.06Ni | 0.280 | 30 | 13 | 30 | 1000 |
| Comparative Example 3 | pb-10Sn | 0.293 | 19 | 46 | 40 | 2000 |
| Comparative Example 4 | Pb-50Sn | 0.296 | 26 | - | 53 | 2500 |
| Conventional Example | pb-50Sn | 0.720 | 26 | - | 53 | > 3500 |

In addition, it should be understood that the technical scope of the invention is not limited to the above embodiments, but various modifications may be made without departing from the spirit and scope of the invention. For example, the cooling sink 31 may be provided with a stress absorbing member including Cu or the like and having a thermal expansion coefficient intermediate between the thermal expansion coefficient of the insulating plate 11 and the thermal expansion coefficient of the main body 31 a of the cooling sink 31, and the stress absorbing member may be disposed between the metal plate 13 and the cooling sink 31, and instead of this stress absorbing member, a strain absorbing member including pure Al having a purity of 99% or more may be disposed.

Moreover, although the above embodiment has shown the configuration in which the whole main body 31a of the cooling sink 31 is formed from pure Al or an Al alloy, a multilayer structure may be adopted in which only the surface of the main body where the metal plate 13 is provided is formed from pure Al or an Al alloy.

Further, the metal plate 13 and the main body 31a of the cooling sink 31 may be joined together by soldering.

### INDUSTRIAL APPLICABILITY

The present invention provides an insulating circuit board and an insulating circuit board having a cooling sink, capable of reducing the total thermal resistance in a laminated direction without reducing the joining reliability between individual components.

## Claims

1. An insulating circuit board comprising an insulating plate, a circuit board joined to one surface of the insulating plate, and a metal plate joined to the other surface of the insulating plate,
wherein the insulating circuit board is made such that semiconductor chips can be joined to the surface of the circuit board via a first solder layer,
the insulating circuit board is made such that a cooling sink can be joined to the lower surface of the metal plate opposite to its surface joined to the insulating plate, via a second solder layer,
the circuit board is formed from an A1 alloy having a purity of 99.98% or more, or pure A1, and
the metal plate is formed from an A1 alloy having a purity of 98.00% or more and 99.90% or less.

2. The insulating circuit board according to Claim 1,
wherein the thickness (a) of the circuit board is set to 0.2 mm or more and 0.8 mm or less,
the thickness (b) of the metal plate is set to 0.6 mm or more and 1.5 mm or less, and
the thicknesses satisfy the expression of a/b ≤ 1.

3. An insulating circuit board having a cooling sink comprising:
the insulating circuit board according to Claim 1; and
a cooling sink joined to the lower surface of the metal plate opposite to its surface joined to the insulating plate, via the second solder layer,
wherein the second solder layer is formed from a solder containing Sn as its main component.

4. The insulating circuit board having a cooling sink according to Claim 3,
wherein the second solder layer has a Young's modulus of 35 GPa or more, a 0.2% proof stress of 30 MPa or more, and a tensile strength of 40 MPa or more.

5. The insulating circuit board having a cooling sink according to Claim 4,
wherein the second solder layer is formed from solder including a ternary or more multi-component alloy containing 85 wt% or more of Sn, 0.5 wt% or more of Ag, and 0.1 wt% or more of Cu.

6. An insulating circuit board comprising an insulating plate, a circuit board joined to one surface of the insulating plate, and a metal plate joined to the other surface of the insulating plate,
wherein the insulating circuit board is made such that semiconductor chips can be joined to the surface of the circuit board,
the insulating circuit board is made such that a cooling sink can be joined to the lower surface of the metal plate opposite to its surface joined to the insulating plate,
the circuit board and the metal plate are formed from pure Al or an Al alloy,
the thickness (a) of the circuit board is 0.2 mm or more and 0.8 mm or less,
the thickness (b) of the metal plate is 0.6 mm or more and 1.5 mm or less, and
the thicknesses satisfy the expression of a/b≤1.

7. An insulating circuit board having a cooling sink comprising:
the insulating circuit board according to Claim 6; and
a cooling sink joined to the lower surface of the metal plate,
wherein the insulating circuit board having a cooling sink is made such that semiconductor chips can be joined to the surface of the circuit board via a first solder layer,
the cooling sink is formed from pure A1 or an A1 alloy, and
the metal plate and the cooling sink are joined together via a second solder layer containing Sn as its main component.

8. An insulating circuit board having a cooling sink comprising:
an insulating circuit board including an insulating plate, a circuit board joined to one surface of the insulating plate, and a metal plate joined to the other surface of the insulating plate; and
a cooling sink provided in the lower surface of the metal plate opposite to its surface joined to the insulating plate,
wherein the insulating circuit board having a cooling sink is made such that semiconductor chips can be joined to the surface of the circuit board via a first solder layer, and
the metal plate and the cooling sink are joined together via a second solder layer containing Sn as its main component and having a Young's modulus of 35 GPa or more, a 0.2% proof stress of 30 MPa or more, and a tensile strength of 40 MPa or more.

9. The insulating circuit board having a cooling sink according to Claim 8,
wherein the second solder layer is formed from solder including a ternary or more multi-component alloy containing 85 wt% or more of Sn, 0.5 wt% or more of Ag, and 0.1 wt% or more of Cu.

10. The insulating circuit board having a cooling sink according to Claim 8,
wherein the cooling sink is formed from pure Al or an Al alloy.

11. The insulating circuit board having a cooling sink according to Claim 8,
wherein the circuit board and the metal plate are formed from pure Al or an Al alloy,
the thickness (a) of the circuit board is 0.2 mm or more and 0.8 mm or less,
the thickness (b) of the metal plate is 0.6 mm or more and 1.5 mm or less, and the thicknesses satisfy the expression of a/b≤1.
